# EUROPEAN PATENT APPLICATION

(11) **EP 4 618 724 A2**
(43) Date of publication of application: **17.09.2025**
(21) Application number: 25156251.8
(22) Date of filing: 06.02.2025
(51) Int. Cl.: H10D 84/01, H10D 30/00, H10D 62/17, H10D 84/03, H10D 84/83, H10D 30/67, H10D 62/10

(54) **CO-INTEGRATION OF GATE-ALL-AROUND DEVICES WITH DIFFERENT NUMBERS OF NANORIBBONS**

(30) Priority: 15.03.2024 US 202418605980
(71) Applicant: Intel Corporation, Santa Clara, CA 95054 (US)
(72) Inventor: BOUCHE, Guillaume, Portland, OR 97217 (US); JUN, Hwichan, Portland, OR 97229 (US); FANG, Sheng-Po, Vancouver, WA 98686 (US)
(74) Representative: HGF

(57) **Abstract**

Techniques are provided herein to form non-planar semiconductor devices (e.g., gate-all-around or forksheet devices) on the same substrate that have a different total number of semiconductor bodies (e.g., nanoribbons) in the channel region. Any number of semiconductor devices each includes one or more semiconductor bodies extending in a first direction, and a gate structure extending in a second direction over each of the semiconductor bodies. Source or drain regions are formed at ends of the one or more semiconductor bodies of each device. Different regions of the substrate have different relative thicknesses, such that devices formed across the different regions have a different number of semiconductor bodies while the gate structures of the devices have a substantially coplanartop surface. In this way, different devices on the substrate can have any number of semiconductor bodies. Topmost semiconductor bodies of each such device may be collinear or coplanar with each other.

## Description

### BACKGROUND

As integrated circuits continue to scale downward in size, a number of challenges arise. For instance, reducing the size of memory and logic cells is becoming increasingly more difficult. Different transistor architectures that maximize available semiconductor surfaces to form active channels have been contemplated, including gate-all-around and forksheet architectures. However, such architectures come with drawbacks with regards to the lack of variability amongst the design of the devices. It can be challenging to adjust the performance between transistors on the same die. Accordingly, there remain a number of non-trivial challenges with respect to forming certain transistor structures.

### BRIEF DESCRIPTION OF THE DRAWINGS

Figure 1 is a cross-sectional view of a pair of semiconductor devices having a different number of total nanoribbons in each device, in accordance with an embodiment of the present disclosure.
Figure 2 is a cross-sectional view of several semiconductor devices on the same substrate having varying numbers of total nanoribbons, in accordance with another embodiment of the present disclosure.
Figures 3A - 3N are cross-section views that illustrate various stages in an example process for forming semiconductor devices having different total numbers of nanoribbons, in accordance with some embodiments of the present disclosure.
Figure 4 is another cross-section view of the semiconductor devices of Figure 3N with an optional dielectric wall between devices, in accordance with an embodiment of the present disclosure.
Figure 5 illustrates a cross-section view of a chip package containing one or more semiconductor dies, in accordance with some embodiments of the present disclosure.
Figure 6 is a flowchart of a fabrication process for semiconductor devices on the same substrate having varying numbers of total nanoribbons, in accordance with an embodiment of the present disclosure.
Figure 7 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form gate-all-around (GAA) semiconductor devices on the same substrate that have a different total number of nanoribbons. The techniques can be used in any number of integrated circuit applications and are particularly useful with respect to GAA transistors (e.g., ribbonFETs and nanowire FETs) or forksheet transistors (e.g., nanosheets). In an example, any number of semiconductor devices each includes one or more nanoribbons extending in a first direction and a gate structure extending in a second direction over each of the nanoribbons. Source and drain regions are formed at the ends of the one or more nanoribbons of each device. According to some embodiments, different regions of the substrate have different relative thicknesses, such that devices formed across the different regions have a different number of resulting nanoribbons while the gate structures of the devices have a substantially coplanar top surface. In this way, different devices on the same substrate can have anywhere between one to four nanoribbons, according to some embodiments. The effective size of the device may be modulated based on how many nanoribbons are present. Advantageously, the techniques do not require depopulation processes within the channel region, which can be damaging to other exposed areas, particularly for relatively tall gate trenches. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. GAA devices provide efficient use of limited chip footprint by providing several semiconductor regions (e.g., nanoribbons) in a single device. However, making changes to the geometry of certain structures across a given die can be challenging. For example, it may be beneficial for many applications to include transistors having different effective sizes (e.g., width/length (W/L) ratio of the gate over the channel region). In the case of GAA devices, the size of the device is affected by various factors, such as the gate length, nanoribbon width, and number of nanoribbons. Some circuits, like memory circuits, may benefit from transistors having a different size compared to other circuits, like logic circuits. Additionally, p-type transistors (P-channel) may benefit from having a generally smaller W/L ratio compared to n-type transistors (N-channel). More generally, some devices may be designed for minimum power consumption (e.g., favoring fewer total nanoribbons) while other devices may be designed to maximize performance at the expense of power consumption (e.g., favoring more total nanoribbons). Changing the effective sizes of transistors across the same substrate or die is challenging, with added complexity and cost when designing densely packed devices. For instance, one possible solution is to remove or trim or depopulate portions of a given channel region by way of a front-side etch process that accesses the channel region via the gate trench prior to forming the final gate structure. However, such processes can be damaging to other exposed areas and cause yield problems, despite any etch selectivity utilized.

Thus, and in accordance with an embodiment of the present disclosure, techniques are provided herein to form non-planar semiconductor devices (e.g., GAA or forksheet devices) on the same substrate with a different total number of nanoribbons in each device. In an example, a first number of GAA devices each includes a first total number of nanoribbons extending along a first direction and a gate structure extending over the first total number of nanoribbons in a second direction substantially orthogonal to the first direction, and a second number of GAA devices each includes a second total number of nanoribbons extending along the first direction and a gate structure extending over the second total number of nanoribbons in the second direction. The first total number of nanoribbons may be any number from one to four (or more), and the second total number of nanoribbons may be any number from one to four (or more) that is different from the first total number of nanoribbons. Any number of GAA devices having any total number of nanoribbons can be formed across the same substrate. Epitaxial source and drain regions are formed that contact the ends of each of the nanoribbons.

According to some embodiments, different regions of the substrate may include additional epitaxial growth to increase the thickness of the substrate compared to other regions of the substrate. Devices formed over thicker substrate regions may include a fewer total number of nanoribbons, with the number of nanoribbons being based at least on the thickness of the substrate region, according to some embodiments. While the topmost nanoribbons of each device may be coplanar or collinear with one another, the lowermost nanoribbons of one or more devices may be in different planes than the lowermost nanoribbons of one or more other devices.

According to an embodiment, an integrated circuit includes a first semiconductor device having one or more first semiconductor nanoribbons extending in a first direction between a first source or drain region and a second source or drain region and a first gate structure extending in a second direction over the one or more first semiconductor nanoribbons, and a second semiconductor device having a plurality of second semiconductor nanoribbons extending in the first direction between a third source or drain region and a fourth source or drain region and a second gate structure extending in the second direction over the plurality of second semiconductor nanoribbons. The second direction is substantially orthogonal to the first direction. A total number of the nanoribbons of the second semiconductor device is greater than a total number of the nanoribbons of the first semiconductor device. The plurality of second semiconductor nanoribbons includes at least one nanoribbon that is coplanar with a portion of a substrate beneath the first gate structure. Also, an upper surface of a topmost nanoribbon of the plurality of first nanoribbons may be coplanar with an upper surface of a topmost nanoribbon of the plurality of second nanoribbons. In some examples, a topmost nanoribbon of the plurality of first nanoribbons may be collinear (e.g., sharing a same central axis that extends linearly along the first direction) with a topmost nanoribbon of the plurality of second nanoribbons. It is possible for two nanoribbons to be collinear but not coplanar (e.g., if they have different thicknesses but are aligned along the same central axis).

According to another embodiment, an integrated circuit includes a first semiconductor device having one or more first semiconductor nanoribbons extending in a first direction between a first source or drain region and a second source or drain region and a first gate structure extending in a second direction over the one or more first semiconductor nanoribbons, and a second semiconductor device having a plurality of second semiconductor nanoribbons extending in the first direction between a third source or drain region and a fourth source or drain region and a second gate structure extending in the second direction over the plurality of second semiconductor nanoribbons. The second direction is substantially orthogonal to the first direction. The plurality of second semiconductor nanoribbons includes at least one nanoribbon that is lower than any nanoribbon of the one or more first semiconductor nanoribbons along a third direction substantially orthogonal to the first and second directions. Also, a topmost nanoribbon of the first semiconductor nanoribbons may be coplanar with a topmost nanoribbon of the second semiconductor nanoribbons. In some examples, a topmost nanoribbon of the first semiconductor nanoribbons may be collinear with a topmost nanoribbon of the second semiconductor nanoribbons.

According to another embodiment, a method of forming an integrated circuit includes forming a base semiconductor layer on a first region of a semiconductor substrate, such that the base semiconductor layer is not present on a second region of the semiconductor substrate; forming a first number of semiconductor layers over the first region of the substrate on the base semiconductor layer and a second number of semiconductor layers over the second region of the substrate, the second number being greater than the first number; forming a first fin comprising the first number of semiconductor layers and the base semiconductor layer extending lengthwise along a first direction, and a second fin comprising the second number of semiconductor layers extending lengthwise along the first direction; forming first source or drain regions at ends of the first number of semiconductor layers and second source or drain regions at ends of the second number of semiconductor layers; and forming a first gate structure extending in a second direction over the first number of semiconductor layers and a second gate structure extending in the second direction over the second number of semiconductor layers.

The techniques can be used with any type of non-planar transistors, but are especially useful for nanoribbon or nanosheet transistors (sometimes called GAA transistors or forksheet transistors, respectively), to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate different devices on the same substrate having different total numbers of nanoribbons. Such tools may also observe devices with a greater number of nanoribbons that include one or more nanoribbons that are below the lowest nanoribbon of the devices having a fewer total number of nanoribbons, according to some embodiments. Similarly, the gate structures of the different devices may be observed to have different heights such that the gate structures around the devices with fewer total nanoribbons have a bottom surface that is higher than a bottom surface of the gate structure around the devices having greater total nanoribbons. Also, the topmost nanoribbon of the various devices may be coplanar and/or collinear with one another.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "backside" generally refers to the area beneath one or more semiconductor devices (below the device layer) either within the device substrate or in the region of the device substrate (in the case where the bulk of the device substrate has been removed). Note that the backside may become a frontside, and vice-versa, if a given structure is flipped. To this end, and as will be appreciated, the use of terms like "above" "below" "beneath" "upper" "lower" "top" and "bottom" are used to facilitate discussion and are not intended to implicate a rigid structure or fixed orientation; rather such terms merely indicate spatial relationships when the structure is in a given orientation.

As used herein, the term "layer" refers to a material portion including a region with a thickness. A monolayer is a layer that consists of a single layer of atoms of a given material. A layer can extend over the entirety of an underlying structure, or under the entirety of an overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

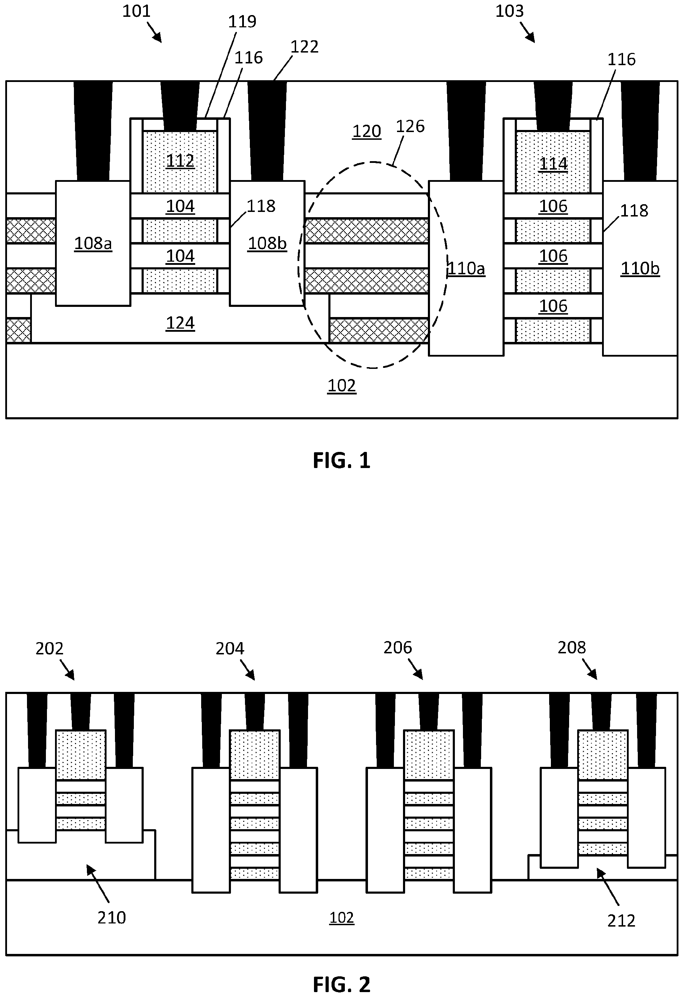

Figure 1 is a cross-sectional view taken across a first semiconductor device 101 and a second semiconductor device 103, according to an embodiment of the present disclosure. Each of first and second semiconductor devices 101 and 103 may be any type of non-planar metal oxide semiconductor (MOS) transistor, such as gate-all-around (GAA), or forksheet transistor. The illustrated embodiments herein use the GAA structure, but they are equally applicable to a forksheet structure. Other non-planar transistor types (e.g., group III-V transistors, such as gallium nitride transistors) and topologies (e.g., any transistor structure having one or more semiconductor bodies covered by a gate structure) may also benefit from the techniques provided herein, as will be appreciated in light of this disclosure.

First and second semiconductor devices 101 and 103 together represent a portion of an integrated circuit that may contain any number of similar semiconductor devices. Additionally, first and second semiconductor devices 101 and 103 are provided side-by-side for clarity and for ease of discussion when comparing and contrasting the devices. However, second semiconductor device 103 could exist anywhere else within the integrated circuit and is not required to be adjacent to first semiconductor device 101.

As can be seen, semiconductor devices 101 and 103 are formed on a substrate 102. Any number of other semiconductor devices can be formed on substrate 102, but two are illustrated here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, a lower portion of (or all of) substrate 102 is removed and replaced with one or more backside interconnect layers to form backside signal and power routing.

First semiconductor device 101 may include a first total number of semiconductor nanoribbons 104, while second semiconductor device 103 may include a second total number of semiconductor nanoribbons 106. Nanoribbons 104 may extend between first source or drain regions 108a and 108b. Likewise, nanoribbons 106 may extend between second source or drain regions 110a and 110b. Any source region may also act as a drain region and vice versa, depending on the application. According to some embodiments, first semiconductor device 101 has a different number of total nanoribbons 104 compared to the total number of nanoribbons 106 from second semiconductor device 103. In the illustrated example, first semiconductor device 101 has two nanoribbons while second semiconductor device 103 has three nanoribbons.

In some embodiments, each of nanoribbons 104 and nanoribbons 106 are formed from a fin of alternating material layers (e.g., alternating layers of silicon and silicon germanium) where sacrificial material layers are removed between nanoribbons 104 and nanoribbons 106. Each of nanoribbons 104 and nanoribbons 106 may include the same semiconductor material as substrate 102, or not, and may be doped, or not. In this example, the upper surface of the topmost nanoribbon 104 is substantially coplanar with the upper surface of the topmost nanoribbon 106. This is because those respective topmost nanoribbons may be formed from the same layer. Other examples may be configured differently. For instance, the topmost nanoribbon 104 may be collinear with the topmost nanoribbon 106, but not necessarily coplanar. In some examples, the topmost nanoribbon 104 may be both coplanar and collinear with the topmost nanoribbon 106.

According to some embodiments, first source or drain regions 108a and 108b and second source or drain regions 110a and 110b are epitaxial regions that are provided using an etch-and-replace process. Any semiconductor materials suitable for source or drain regions can be used (e.g., group IV and group III-V semiconductor materials). Source or drain regions 108/110 may include multiple layers such as liners and capping layers to improve contact resistance. In any such cases, the composition and doping of source or drain regions 108/110 may be the same or different, depending on the polarity of the transistors. Any number of source and drain configurations and materials can be used. In some embodiments, the height of first source or drain regions 108a and 108b are less than the height of second source or drain regions 110a and 110b, such that a bottom surface of first source or drain regions 108a/108b is at least 10 nm above a bottom surface of second source or drain regions 110a/110b. According to some embodiments, the height of a source or drain region of a given device is related, at least in part, to the total number of nanoribbons of the given device. In other embodiments, all devices include source or drain regions having substantially the same height.

According to some embodiments, the semiconductor material of nanoribbons 104 and 106 can be formed of material deposited over the underlying substrate 102. In one such example case, a blanket layer of silicon germanium (SiGe) can be deposited over a silicon substrate, and then patterned and etched to form a plurality of SiGe nanoribbons. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins or deposited into fin-shaped trenches.

According to some embodiments, a first gate structure 112 extends over each of nanoribbons 104 between spacer structures 116 and inner spacers 118 along a second direction into and out of the page. Similarly, a second gate structure 114 extends over each of nanoribbons 106 between spacer structures 116 and inner spacers 118 along the second direction. Each of first and second gate structures 112 and 114 include both a gate dielectric (not shown) around the corresponding nanoribbons and a gate electrode over the gate dielectric. The gate dielectric may also be deposited along sidewalls and the bottom of the trench between spacer structures 116 and inner spacers 118. The gate dielectric may include a single material layer or multiple stacked material layers. In some embodiments, the gate dielectric includes a first dielectric layer such as silicon oxide and a second dielectric layer that includes a high-k material such as hafnium oxide. Some other examples high-k materials include, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. The high-k material may be doped with an element to affect the threshold voltage of the given semiconductor device. According to some embodiments, a doping element is used in the gate dielectric, such as lanthanum.

According to some embodiments, first and second gate structures 112 and 114 include a gate electrode that extends over the gate dielectric around each of nanoribbons 104 and 106, respectively. The gate electrode may include any sufficiently conductive material such as a metal (e.g., tungsten), metal alloy, or doped polysilicon. According to some embodiments, the gate electrode may be interrupted between any other semiconductor devices by a gate cut structure. In some embodiments, the gate electrode includes one or more workfunction metals around the corresponding nanoribbons. For example, a p-channel device includes a workfunction metal having titanium and an n-channel device includes a workfunction metal having tungsten. In some embodiments, the gate electrode includes a fill metal or other conductive material around any workfunction metal(s) to provide the whole gate electrode structure.

The gate spacer structures 116 are present on sidewalls of gate structures 112/114 to separate the gate structures from the source/drain trenches. Accordingly, spacer structures 116 extend along the second direction with gate structures 112/114. Spacer structures 116 may include any suitable dielectric material, such as silicon nitride or silicon oxynitride, and may include multiple layers such as a first layer of silicon nitride and a second layer of silicon dioxide on the layer of silicon nitride. Inner spacers 118 may also be used to separate the gate structures from the source/drain trenches between the nanoribbons. Accordingly, inner spacers 118 may be provided around the ends of nanoribbons 104 and 106. Inner spacers 118 may include the same dielectric material as spacer structures 116 or may include any other suitable dielectric material. According to some embodiments, a top surface of the gate electrodes may be recessed between spacer structures 116 and a gate cap 119 may be formed within the recess. Gate cap 119 can include any suitable dielectric material, such as silicon nitride or silicon oxynitride. In some examples, gate cap 119 includes the same dielectric material as spacer structures 116.

According to some embodiments, a dielectric structure 120 is present over devices 101 and 103. Dielectric structure 120 may represent any number of dielectric layers to protect the elements of devices 101 and 103. In some examples, dielectric structure 120 includes one or more material layers of silicon dioxide. According to some embodiments, contacts 122 extend through at least a portion of dielectric structure 120 to make electrical contact with the top surface of various transistor elements. In the illustrated example, contacts 122 extend through dielectric structure 120 to contact the top surfaces of each of first source or drain regions 108a/108b, second source or drain regions 110a/110b, and the gate electrodes of gate structures 112 and 114. Contacts 122 can include any suitable conductive material, such as tungsten, copper, cobalt, titanium, ruthenium, tantalum, or molybdenum, or alloys of any of these. Contacts 122 may also include multiple layers, such as barrier and/or liner layers to inhibit electromigration and/or improve adhesion and contact resistance (e.g., layer of tantalum, titanium, or nitrides of same).

According to some embodiments, first semiconductor device 101 is formed over a first region of substrate 102 and second semiconductor device 103 is formed over a second region of substrate 102. The first region of substrate 102 includes a mesa structure 124 that effectively increases the thickness of substrate 102 in the first region. According to some embodiments, mesa structure 124 includes the same material (e.g., the same material composition) as substrate 102. For example, mesa structure 124 may be epitaxially grown silicon on the surface of a silicon substrate 102. A visible seam may or may not be present between mesa structure 124 and substrate 102. The thickness of mesa structure 124 may be used to control the total number of nanoribbons present in any devices formed above it, according to some embodiments. In the illustrated example, mesa structure 124 may have a thickness between about 15 nm and about 30 nm to effectively fill in for a missing nanoribbon at the bottom of first semiconductor device 101.

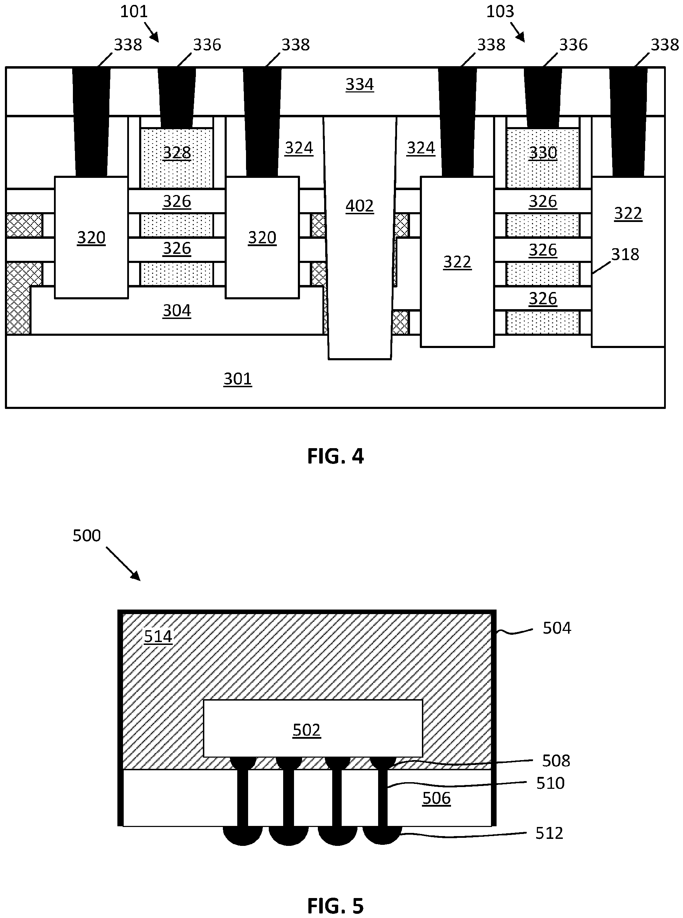

According to some embodiments, a multilayer region 126 may be present between adjacent semiconductor devices 101 and 103. Multilayer region 126 may include portions of alternating semiconductor layers left behind following the fabrication process of devices 101 and 103. According to some embodiments, multilayer region 126 includes one or more semiconductor layers extending between source or drain region 108b of first semiconductor device 101 and source or drain region 110a of second semiconductor device 103. In such examples, source or drain regions 108b and 110a are conductively coupled together via the semiconductor layers of multilayer region 126. In other embodiments, a dielectric structure is formed through at least an entire height of multilayer region 126 to electrically isolate source or drain regions 108b and 110a (such as shown in the example of Figure 4).

Figure 2 illustrates a cross section view of various semiconductor devices 202, 204, 206, and 208 across substrate 102. According to some embodiments, the semiconductor devices are formed in different regions of substrate 102 that have different thicknesses due to the presence of mesa structures. In the illustrated example, a first semiconductor device 202 is formed in a first region of substrate 102 over a first mesa structure 210, a second semiconductor device 204 and a third semiconductor device 206 are formed in a second region of substrate 102 without a mesa structure, and a third semiconductor device 208 is formed in a third region of substrate 102 over a second mesa structure 212. Second and third semiconductor devices 204 and 206 each have four nanoribbons based on the number of alternating material layers formed on the substrate (e.g., a greater number of material layers results in a greater number of nanoribbons). First semiconductor device 202 only includes two total nanoribbons due to the presence of first mesa structure 210 having a first thickness while fourth semiconductor device 208 only includes three total nanoribbons due to the presence of second mesa structure 212 having a second thickness less than the first thickness. Any number of devices can be arranged across the substrate to have any total number of nanoribbons by arranging the location of mesa structures with different heights.

### Fabrication Methodology

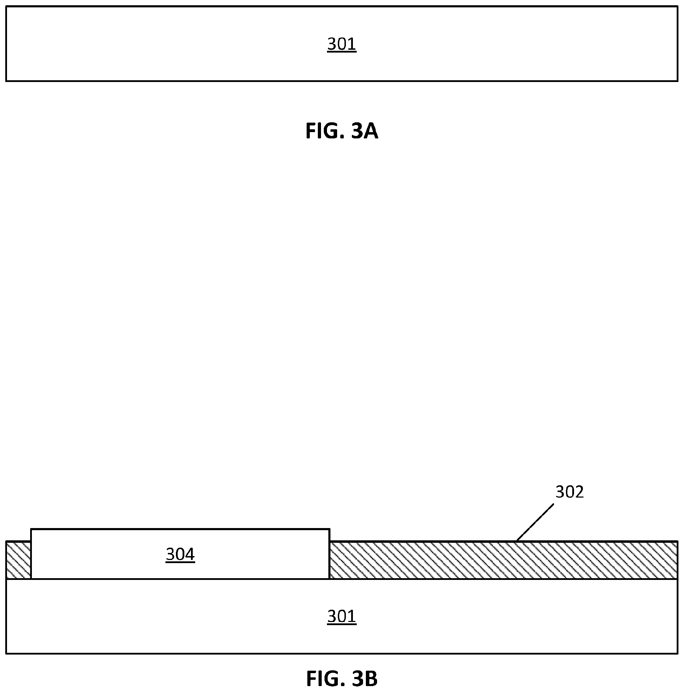

Figures 3A - 3N include cross-sectional views that collectively illustrate an example process for forming an integrated circuit configured with semiconductor devices having a different total number of nanoribbons, according to some embodiments. Each figure shows an example structure that results from the process flow up to that point in time, so the depicted structure evolves as the process flow continues, culminating in the structure shown in Figure 2N, which is similar to the structure shown in Figure 1. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 3A illustrates a cross-sectional view of a substrate 301. Like substrate 102 discussed above, substrate 301 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 301 can be a semiconductor-on-insulator substrate having a desired semiconductor layer over a buried insulator layer (e.g., silicon over silicon dioxide).

Figure 3B illustrates a cross-sectional view of the substrate shown in Figure 3A following the formation of a mask layer 302 and the formation of a mesa structure 304. Mask layer 302 may be any suitable hard mask dielectric material, such as silicon nitride, silicon dioxide, silicon oxynitride. Mask layer 302 may be patterned using any suitable lithography technique to form an opening that exposes a first region of substrate 301. According to some embodiments, mesa structure 304 is formed on the exposed first region of substrate 301. Mesa structure 304 may be the same material as substrate 301. In one example, both mesa structure 304 and substrate 301 are silicon. Mesa structure 304 may be epitaxially grown on the exposed surface of substrate 301.

According to some embodiments, a thickness of mesa structure 304 can control the total number of nanoribbons for any devices formed over mesa structure 304. Mesa structures having different thicknesses may be formed across substrate 301. In some examples, mesa structure 304 has a thickness between about 15 nm and about 30 nm to yield devices having one fewer nanoribbon compared to devices not formed on a mesa structure. In other examples, mesa structure 304 is made thicker (e.g., greater than 40 nm) to yield devices having two or more fewer nanoribbons compared to the devices not formed on a mesa structure.

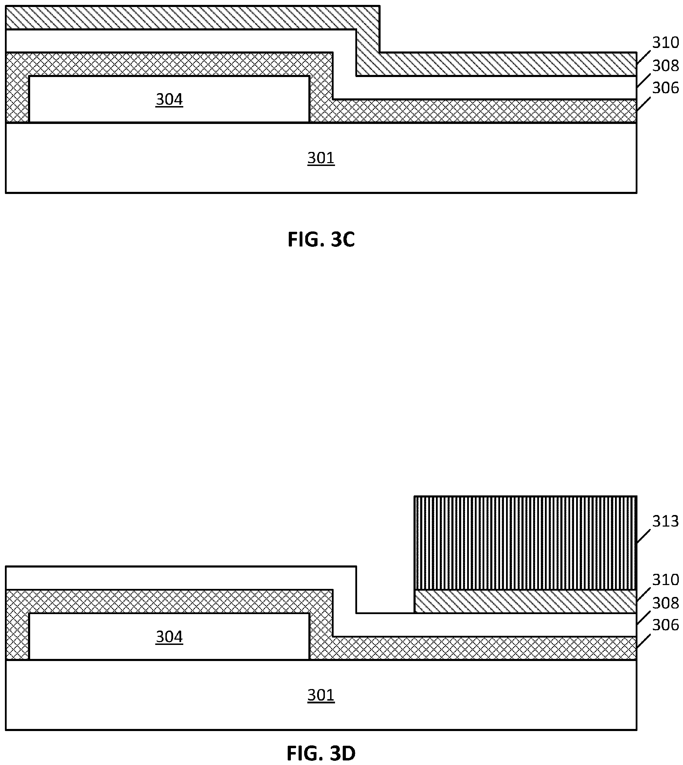

Figure 3C illustrates a cross-sectional view of the structure shown in Figure 3B following the formation of a sacrificial layer 306, semiconductor layer 308, and mask layer 310, according to some embodiments. According to some embodiments, sacrificial layer 306 has a different material composition than semiconductor layer 308. In some embodiments, sacrificial layer 306 is silicon germanium (SiGe) while semiconductor layer 308 includes a semiconductor material suitable for use as a nanoribbon such as silicon (Si), SiGe, germanium, or III-V materials like indium phosphide (InP) or gallium arsenide (GaAs). In examples where SiGe is used in each of sacrificial layer 306 and in semiconductor layer 308, the germanium concentration is different between sacrificial layer 306 and semiconductor layer 308. For example, sacrificial layer 306 may include a higher germanium content compared to semiconductor layer 308. In some examples, sacrificial layer 306 includes a germanium concentration between about 10% and about 50%.

While dimensions can vary from one example embodiment to the next, the thickness of sacrificial layer 306 may be between about 5 nm and about 20 nm and the thickness of semiconductor layer 308 may be about the same as the thickness of sacrificial layer 306 (e.g., about 5-20 nm). Sacrificial layer 306 and semiconductor layer 308 may be deposited using any known material deposition technique, such as chemical vapor deposition (CVD), plasma-enhanced chemical vapor deposition (PECVD), physical vapor deposition (PVD), atomic layer deposition (ALD), or may be formed via epitaxial growth.

Mask layer 310 may be similar to mask layer 302 and may be any suitable hard mask dielectric material, such as silicon nitride, silicon dioxide, silicon oxynitride. Note that in this example, mesa structure 304 has a thickness that is substantially the same (e.g., within 2 nm) as a sum of the thicknesses of sacrificial layer 306 and semiconductor layer 308. According to some embodiments, alternating layers of sacrificial layers 306 and semiconductor layers 308 may be deposited until a top surface of a semiconductor layer 308 is substantially coplanar with a top surface of mesa structure 304.

Figure 3D illustrates a cross-sectional view of the structure shown in Figure 3C following the lithographic patterning of mask layer 310, according to some embodiments. A mask material 313 is first patterned to remain over a second region of substrate 301, and is used to transfer its pattern into the underling mask layer 310 using, for example, a reactive ion etching (RIE) process. Mask material 313 may be any suitable photoresist or hard mask material, such as carbon hard mask (CHM).

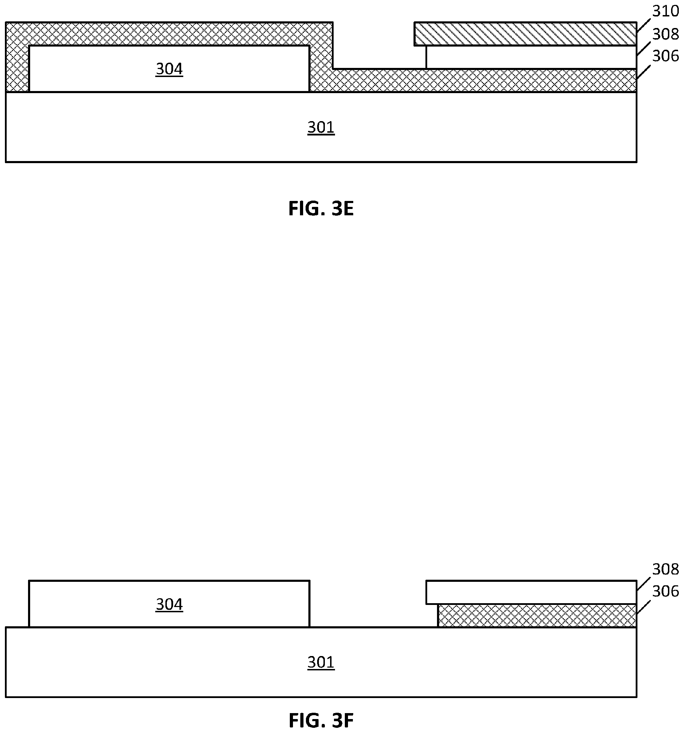

Figure 3E illustrates a cross-sectional view of the structure shown in Figure 3D following the removal of mask layer 310 and stripping of exposed portions of semiconductor layer 308, according to some embodiments. Mask layer 310 protects a portion of semiconductor layer 308 over the second region of substrate 301 while an isotropic etching process may be used to remove exposed portions of semiconductor layer 308. The etching process may selectively remove the material of semiconductor layer 308 while removing little to none of the material of sacrificial layer 306.

Figure 3F illustrates a cross-sectional view of the structure shown in Figure 3E following the stripping of exposed portions of sacrificial layer 306, according to some embodiments. An isotropic etching process may be used to selectively removed exposed portions of sacrificial layer 306 while removing little to none of the material of semiconductor layer 308, mesa structure 304, and substrate 301. In some examples, mask layer 310 is also removed prior to the removal of portions of sacrificial layer 306. At this stage, the first region of substrate 301 includes mesa structure 304 while the second region of substrate 301 includes any number of alternating layers of sacrificial layers 306 and semiconductor layers 308 (one of each in the illustrated example). According to some embodiments, a top surface of a topmost semiconductor layer 308 in the second region is substantially coplanar with a top surface of mesa structure 304.

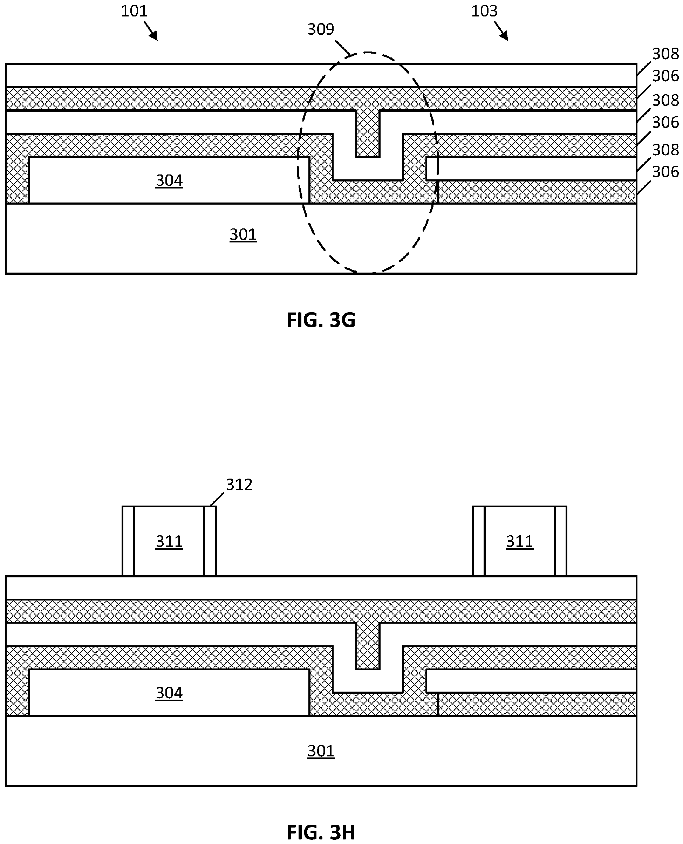

Figure 3G illustrates a cross-sectional view of the structure shown in Figure 3F following the formation of any number of additional alternating sacrificial layers 306 and semiconductor layers 308, according to some embodiments. Each of sacrificial layers 306 may have the same material composition and thickness (e.g., 5 - 20 nm) and each of semiconductor layers 308 may have the same material composition and thickness (e.g., 5 - 20 nm). The resulting structure includes first semiconductor device 101 over the first region of substrate 301 (e.g., on mesa structure 304) with a first number of semiconductor layers 308 and second semiconductor device 103 over the second region of the substrate with a second number of semiconductor layers 308 different from the first number of semiconductor layers. In the illustrated example, first semiconductor device 101 includes two semiconductor layers 308, and second semiconductor device 103 includes three semiconductor layers 308. Note how the topmost layer 308 is shared by both devices, in this example, which allows for the uppermost surfaces of the topmost nanoribbons (or nanosheets, or other bodies of semiconductor material, as the case may be) of devices 101 and 103 to be coplanar with one another. A transition region 309 between first semiconductor device 101 and second semiconductor device 103 can include various orientations of the different material layers as they are deposited over semiconductor regions having different surface heights.

According to some embodiments, the layer structure across substrate 301 is patterned into parallel fins that extend above the surface of substrate 301. The cross-section view of Figure 3G may be taken along the length of the fin as it extends above the surface of substrate 301. Accordingly, the fin may include mesa structure 304 and the alternating material layers of sacrificial layers 306 and semiconductor layers 308.

Figure 3H illustrates a cross-sectional view of the structure shown in Figure 3G following the formation of sacrificial gate structures 311 and spacer structures 312 over the alternating layer structure of the fin, according to an embodiment. Sacrificial gate structures 311 may run in an orthogonal direction to the length of the fin and may include any material that can be safely removed later in the process without etching or otherwise damaging any portions of the fin or of spacer structures 312. In some embodiments, sacrificial gate structures 311 include polysilicon. Spacer structures 312 may be formed using an etch-back process where spacer material is deposited everywhere and then anisotropically etched to leave the material only on sidewalls of structures including sacrificial gate structures 311. Spacer structures 312 may include a dielectric material, such as silicon nitride, silicon oxy-nitride, or any formulation of those layers incorporating carbon or boron dopants. Sacrificial gate structures 311 together with spacer structures 312 define portions of the fin that will be used to form source and drain regions of the first and second semiconductor devices, as discussed further herein. One sacrificial gate structure 311 is formed over mesa structure 304 in the first region of the substrate while another sacrificial gate structure 311 is formed over the second region of the substrate (e.g., no mesa structure).

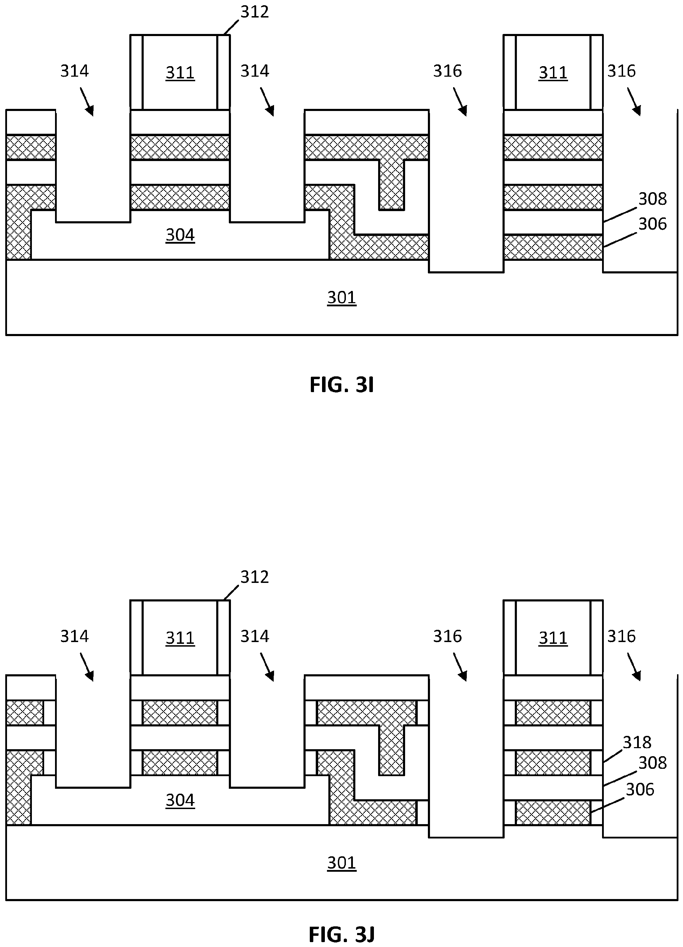

Figure 3I illustrates a cross-sectional view of the structure shown in Figure 3H following the removal of portions of the exposed fin adjacent to sacrificial gate structures 311 and spacer structures 312, according to an embodiment of the present disclosure. According to some embodiments, the various alternating material layers are etched in a directional fashion (downward) at substantially the same rate using an RIE process. The RIE process may also etch into substrate 102 or mesa structure 304 thus recessing portions of substrate 102 or mesa structure 304 on either side of any of the fins. The geometry of the source/drain opening being formed may vary from one example to the next, but in some cases are relatively narrow and deep, such as recesses having a 2:1 or higher height-to-width aspect ratio (e.g., 3:1, 4:1, 5:1, 8:1).

According to some embodiments, different etch processes are used to form openings 314 adjacent to the fin over mesa structure 304 and to form openings 316 adjacent to the fin in the second region of substrate 301. By using different processes, the depths of openings 314 and 316 can be different. In the illustrated example, openings 314 are etched to a depth that may be 3-5 nm or 5-10 nm below a top surface of mesa structure 304 while openings 316 are etched to a depth that may be 3-5 nm or 5-10 nm below a top surface of substrate 301. Other examples may be configured differently with respect to such dimensions, as is the case with other example dimensions provided herein.

Figure 3J illustrates a cross-sectional view of the structure shown in Figure 3I following the removal of exposed portions of sacrificial layers 306 and subsequent formation of inner spacers 318, according to an embodiment of the present disclosure. An isotropic etching process may be used to recess the exposed ends of each of sacrificial layers 306 (e.g., within each of openings 314/316) while not etching (or etching relatively little of) semiconductor layers 308. Inner spacers 318 may then be formed by conformally depositing a dielectric material over the sidewalls of the fins using a CVD process like ALD and then etching back the dielectric material using an isotropic etching process to expose the ends of semiconductor layers 308 within openings 314/316. Inner spacers 318 may be any suitable dielectric material that exhibits high etch selectively to semiconductor materials such as silicon and/or silicon germanium. In some examples, inner spacers 318 have the same material composition as spacer structures 312.

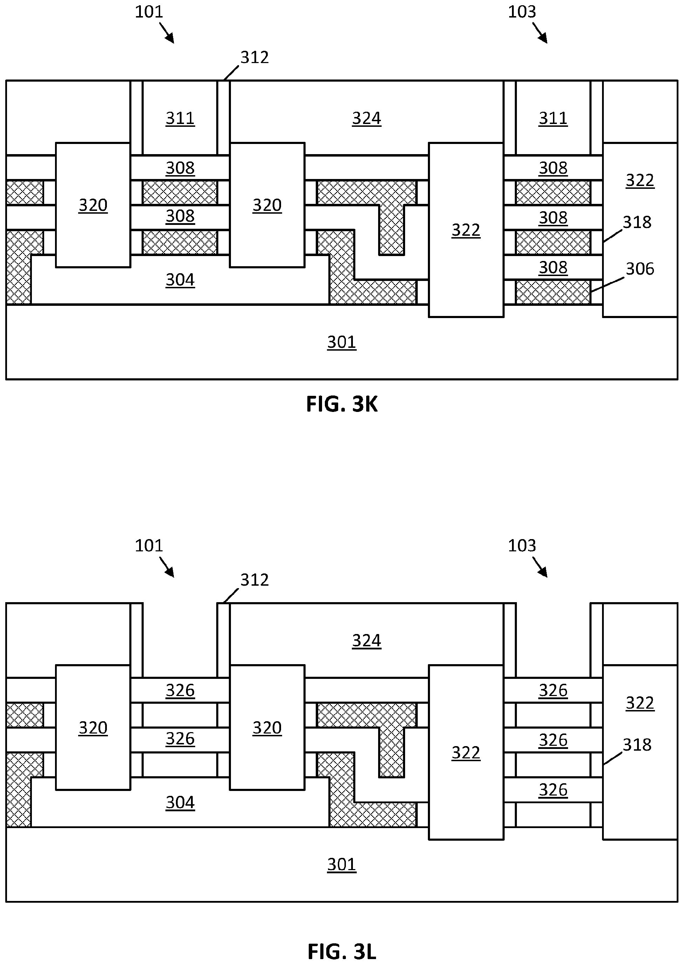

Figure 3K illustrates a cross-sectional view of the structure shown in Figure 3J following the formation of first source or drain regions 320 within openings 314 and second source or drain regions 322 within openings 316, according to an embodiment of the present disclosure. As noted above, any of source or drain regions 320/322 can act as either a source or drain depending on the application. In some examples, source or drain regions 320/322 are epitaxially grown from the ends of semiconductor layers 308. Any semiconductor materials suitable for source or drain regions 320/322 can be used (e.g., group IV and group III-V semiconductor materials). Source or drain regions 320/322 may include multiple layers such as liners and capping layers to improve contact resistance. In any such cases, the composition and doping of source or drain regions 320/322 may be the same or different, depending on the polarity of the transistors. Any number of source or drain configurations and materials can be used.

Due to the presence of mesa structure 304, bottom surfaces of first source or drain regions 320 are higher (e.g., along a third, vertical direction up and down the page) than bottom surfaces of second source or drain regions 322, according to some embodiments. The distance between the bottom surfaces of first source or drain regions 320 and the bottom surfaces of second source or drain regions 322 may be substantially equal to the thickness of mesa structure 304. In some examples, the distance between the bottom surfaces of first source or drain regions 320 and the bottom surfaces of second source or drain regions 322 along the third direction is at least 10 nm, at least 15 nm, at least 20 nm, or at least 25 nm. In some other embodiments, each of first source or drain regions 320 and second source or drain regions 322 have substantially the same height (e.g., openings 314 and 316 are etched to substantially the same depth).

According to some embodiments, a dielectric structure 324 is formed on a region above source or drain regions 320/322. Dielectric structure 324 may include any number of dielectric layers. A top surface of dielectric structure 324 may be polished using, for example, chemical mechanical polishing (CMP) to be substantially coplanar with a top surface of sacrificial gate structure 311 and/or spacer structures 312. Dielectric structure 324 may include any suitable dielectric material. In some examples, dielectric structure 324 includes silicon dioxide or any dielectric material having a high etch selectivity compared with the dielectric material of spacer structures 312.

Figure 3L illustrates a cross-sectional view of the structure shown in Figure 3K following the removal of the sacrificial gate structures 311 and sacrificial layers 306, according to an embodiment of the present disclosure. The sacrificial gate structures 311 may be removed using any wet or dry isotropic process thus exposing the alternating layer stack of the fins within the trenches left behind after the removal of sacrificial gate structures 311. Once sacrificial gate structures 311 have been removed, the exposed sacrificial layers 306 may also be removed using a selective isotropic etching process that removes the material of sacrificial layers 306 but does not remove (or removes very little of) semiconductor layers 308. At this point, the suspended semiconductor layers 308 form nanoribbons 326 (or nanowires or nanosheets) that extend between corresponding first source or drain regions 320 or between corresponding second source or drain regions 322. Note that a plane extending along the first direction and second direction intersects both mesa structure 304 and the bottom-most nanoribbon 326 of second semiconductor device 103, according to some embodiments.

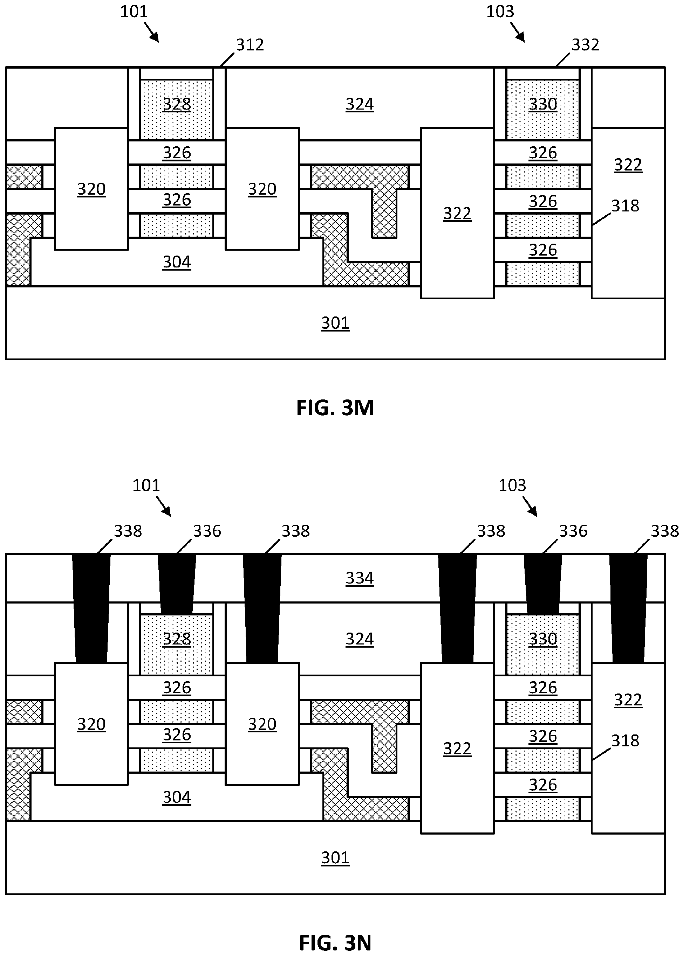

Figure 3M illustrates a cross-sectional view of the structure shown in Figure 3L following the formation of a first gate structure 328 around the suspended nanoribbons 326 of first semiconductor device 101 and a second gate structure 330 around the suspended nanoribbons 326 of second semiconductor device 103, according to an embodiment of the present disclosure. As noted above, gate structures 328/330 each include a gate dielectric and a gate electrode.

The gate dielectric may be conformally deposited around nanoribbons 326 using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 0.5 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on nanoribbons 326, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary conductive material that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. In one example, a semiconductor device is a PMOS device and the workfunction layers include, for example, p-type workfunction materials (e.g., titanium nitride). In the case of an NMOS device, n-type workfunction materials can include titanium aluminum carbide. Due to the presence of mesa structure 304, a bottom surface of a portion of first gate structure 328 (e.g., beneath nanoribbons 326 of first semiconductor device 101) is higher than a bottom surface of second gate structure 330 (e.g., beneath nanoribbons 326 of second semiconductor device 103). The distance between the bottom surface of gate structure 328 above mesa structure 304 and the bottom surface of gate structure 330 along a third direction (e.g., vertical direction up and down the page) may be substantially equal to the thickness of mesa structure 304. In some examples, the distance between the bottom surface of gate structure 328 above mesa structure 304 and the bottom surface of gate structure 330 along the third direction is at least 10 nm, at least 15 nm, at least 20 nm, or at least 25 nm.

According to some embodiments, a top portion of the gate electrode of each gate structure 328/330 may be recessed below a top surface of spacer structures 312. The recess may be filled with a dielectric material to form gate caps 332 to protect the gate electrodes. Gate caps 332 may be any suitable dielectric material, such as silicon nitride. In some examples, gate caps 332 have the same material composition as spacer structures 312.

Figure 3N illustrates a cross-sectional view of the structure shown in Figure 3M following the formation of an additional dielectric structure 334 and contacts 336/338 through dielectric structure 334, according to some embodiments. Dielectric structure 334 may be similar to dielectric structure 324, and thus may include any number of dielectric layers. Dielectric structure 334 may include the same material composition as dielectric structure 324 (e.g., both dielectric structures may be silicon dioxide).

According to some embodiments, gate contacts 336 extend through dielectric structure 334 and gate cap 332 (if present) to contact a top surface of the gate electrodes. Similarly, source/drain contacts 338 extend through dielectric structure 334 and at least a portion of dielectric structure 324 to contact a top surface of corresponding source or drain regions 320/322. Contacts 336 and 338 may be any suitable conductive material for making electrical contact with the underlying gate electrodes or source or drain regions 320/322. In some embodiments, contacts 336 and 338 include tungsten, copper, cobalt, titanium, ruthenium, molybdenum, or tantalum.

As can be seen in Figure 3N, some semiconductor layers remain between first source or drain region 320 of first semiconductor device 101 and second source or drain region 322 of second semiconductor device 103. These layers may remain to electrically couple the adjacent source or drain regions together, which may be utilized in certain circuit designs (e.g., an inverter).

Figure 4 illustrates another embodiment of the structure shown in Figure 3N, where a dielectric structure 402 has been formed between first semiconductor device 101 and second semiconductor device 103. Accordingly, dielectric structure 402 may extend through at least each of the semiconductor layers between the devices, such that dielectric structure 402 electrically isolates first source or drain region 320 from second source or drain region 322. Dielectric structure 402 may include any suitable dielectric material, such as silicon dioxide, silicon nitride, or silicon oxynitride, or a combination of such materials, such as a high-k liner material and low-k fill material. Note there may be remnants of the multilayer region (e.g., 126) or transition region (e.g., 309) on one or both sides of dielectric structure 402.

Figure 5 illustrates an example embodiment of a chip package 500, in accordance with an embodiment of the present disclosure. As can be seen, chip package 500 includes one or more dies 502. One or more dies 502 may include at least one integrated circuit having semiconductor devices, such as any of the semiconductor devices disclosed herein. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Methodology

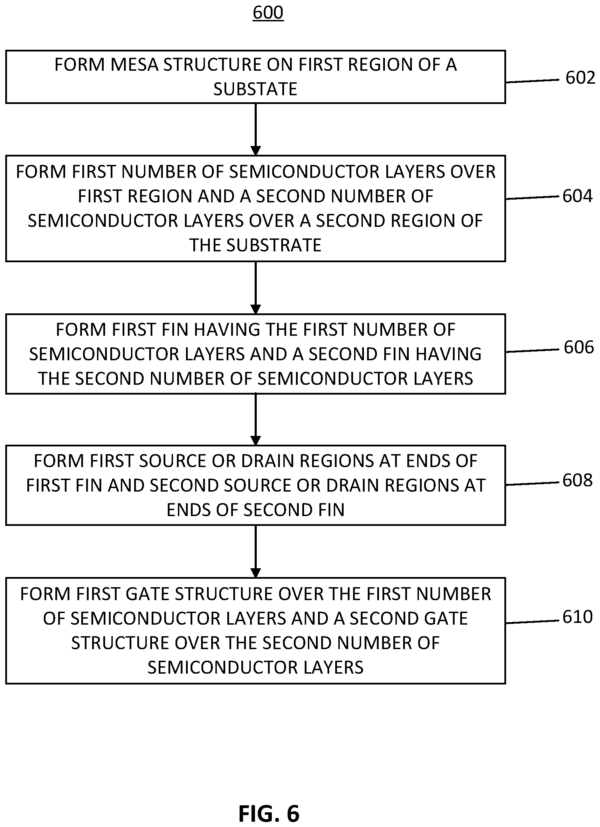

Figure 6 is a flow chart of a method 600 for forming at least a portion of an integrated circuit, according to an embodiment. Various operations of method 600 may be illustrated in Figures 3A-3N. However, the correlation of the various operations of method 600 to the specific components illustrated in the aforementioned figures is not intended to imply any structural and/or use limitations. Rather, the aforementioned figures provide one example embodiment of method 600. Other operations may be performed before, during, or after any of the operations of method 600. Some of the operations of method 600 may be performed in a different order than the illustrated order.

Method 600 begins with operation 602 where a mesa structure is formed over a first region of a substrate. The mesa structure may include the same material as the substrate, such as silicon. According to some embodiments, the mesa structure may be epitaxially grown on the first region of the substrate. A total thickness of the mesa structure may be used to control the number of nanoribbons of any devices formed over the mesa structure (e.g., thicker mesa structure yields fewer number of nanoribbons). Any number of mesa structures having different thicknesses can be formed across the substrate to yield different substrate regions with devices having a different number of total nanoribbons.

Method 600 continues with operation 604 where a first number of semiconductor layers are formed over the first substrate region and a second number of semiconductor layers are formed over a second region of the substrate. The semiconductor layers may be deposited using any known CVD or PVD technique and may each have a thickness between about 5 nm and about 20 nm. In some embodiments, the semiconductor layers alternate with sacrificial layers that may also include a semiconductor material different from those in the semiconductor layers. According to some embodiments, there are fewer semiconductor layers above the mesa structure in the first region of the substrate (the first number of semiconductor layers) compared to the number of semiconductor layers in the second region of the substrate (the second number of semiconductor layers).

Method 600 continues with operation 606 where a first fin is formed having the first number of semiconductor layers extending above the substrate and a second fin is formed having the second number of semiconductor layers extending above the substrate. In some embodiments, the first fin also includes at least a portion of the mesa structure. An RIE process may be used to etch through the various semiconductor layers to form the first and second fins. A portion of the mesa structure may also be etched through to form the first fin. In some embodiments, the first and second fins have exposed ends of the semiconductor layers at the ends of the fins where source or drain regions are to be formed.

The first and second fins may be located at any position on the substrate. In some embodiments, the first and second fins are aligned along the same first direction, such that the first and second fins were originally part of a same fin before being separated into the first and second fins.

Method 600 continues with operation 608 where first source or drain regions are formed at the ends of the first number semiconductor layers of the first fin and second source or drain regions are formed at the ends of the second number of semiconductor layers of the second fin. In some examples, the first and second source or drain regions are epitaxially grown from the exposed ends of the semiconductor layers. Any semiconductor materials suitable for source or drain regions can be used (e.g., group IV and group III-V semiconductor materials). The first and second source or drain regions may include multiple layers such as liners and capping layers to improve contact resistance. In any such cases, the composition and doping of the first and second source or drain regions may be the same or different, depending on the polarity of the transistors.

According to some embodiments, first source or drain regions may have a smaller height compared to second source or drain regions. For example, top surfaces of first source or drain regions and second source or drain regions may be substantially coplanar while bottom surfaces of first source or drain regions are higher (e.g., along a third, vertical direction) than bottom surfaces of second source or drain regions by a given distance. The given distance may be substantially equal to the thickness of the mesa structure.

Method 600 continues with operation 610 where a first gate structure is formed over the first number of semiconductor layers and a second gate structure is formed over the second number of semiconductor layers. As discussed above, each of the first and second gate structures includes a gate dielectric and a gate electrode on the gate dielectric. In some embodiments, the first and second gate structures are aligned along the second direction within the same gate trench. According to some embodiments, top surfaces of the first and second gate structures are substantially coplanar. According to some embodiments, a bottom surface of the first gate structure beneath the first number of semiconductor layers is higher (e.g., along a third, vertical direction) than a bottom surface of the second gate structure beneath the second number of semiconductor layers by a given distance. The given distance may be substantially equal to the thickness of the mesa structure. In some examples, the upper surface of the topmost semiconductor layer under the first gate structure is substantially coplanar with the upper surface of the topmost semiconductor layer under the second gate structure. Other examples may be configured differently. For instance, the topmost semiconductor layer under the first gate structure may be collinear with the topmost semiconductor layer under the second gate structure, but not necessarily coplanar, such as the example case where one of those topmost semiconductor layers is thinner (or thicker) than the other topmost semiconductor layer. In still other examples, the topmost semiconductor layers may be both coplanar and collinear with each other.

### Example System

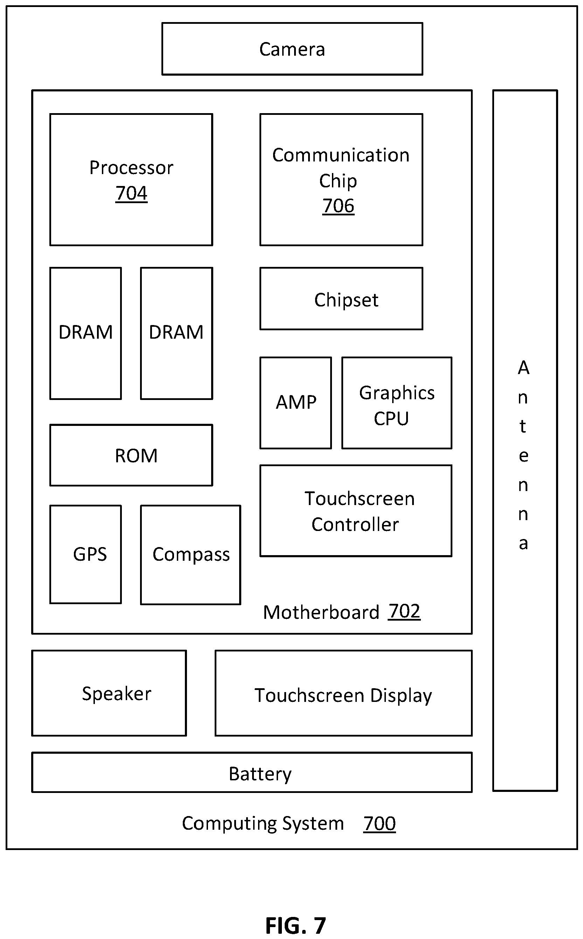

FIG. 7 is an example computing system implemented with one or more of the integrated circuit structures as disclosed herein, in accordance with some embodiments of the present disclosure. As can be seen, the computing system 700 houses a motherboard 702. The motherboard 702 may include a number of components, including, but not limited to, a processor 704 and at least one communication chip 706, each of which can be physically and electrically coupled to the motherboard 702, or otherwise integrated therein. As will be appreciated, the motherboard 702 may be, for example, any printed circuit board (PCB), whether a main board, a daughterboard mounted on a main board, or the only board of system 700, etc.

Depending on its applications, computing system 700 may include one or more other components that may or may not be physically and electrically coupled to the motherboard 702. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 700 may include one or more integrated circuit structures or devices configured in accordance with an example embodiment (e.g., a module including an integrated circuit on a substrate, the substrate having semiconductor devices with different total numbers of nanoribbons, as variously provided herein). In some embodiments, multiple functions can be integrated into one or more chips (e.g., for instance, note that the communication chip 706 can be part of or otherwise integrated into the processor 704).

The communication chip 706 enables wireless communications for the transfer of data to and from the computing system 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing system 700 includes an integrated circuit die packaged within the processor 704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 706 also may include an integrated circuit die packaged within the communication chip 706. In accordance with some such example embodiments, the integrated circuit die of the communication chip includes one or more semiconductor devices as variously described herein. As will be appreciated in light of this disclosure, note that multistandard wireless capability may be integrated directly into the processor 704 (e.g., where functionality of any chips 706 is integrated into processor 704, rather than having separate communication chips). Further note that processor 704 may be a chip set having such wireless capability. In short, any number of processor 704 and/or communication chips 706 can be used. Likewise, any one chip or chip set can have multiple functions integrated therein.

In various implementations, the computing system 700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device comprising one or more first semiconductor bodies extending in a first direction between a first source or drain region and a second source or drain region, and a first gate structure extending in a second direction over the one or more first semiconductor bodies, and a second semiconductor device comprising a plurality of second semiconductor bodies extending in the first direction between a third source or drain region and a fourth source or drain region, and a second gate structure extending in the second direction over the plurality of second semiconductor bodies. The second direction is substantially orthogonal to the first direction. A total number of the semiconductor bodies of the second semiconductor device is greater than a total number of the semiconductor bodies of the first semiconductor device. The plurality of second semiconductor bodies includes at least one body that is coplanar with a portion of a substrate beneath the one or more first semiconductor bodies.

Example 2 includes the integrated circuit of Example 1, wherein the plurality of second semiconductor bodies includes at least one semiconductor body that is lower than any semiconductor body of the one or more first semiconductor bodies along a third direction substantially orthogonal to the first and second directions.

Example 3 includes the integrated circuit of Example 1 or 2, wherein a bottom surface of the first source or drain region and second source or drain region is at least 10 nm higher than a bottom surface of the third source or drain region and the fourth source or drain region along a third direction substantially orthogonal to the first and second directions.

Example 4 includes the integrated circuit of any one of Examples 1-3, wherein the first and second source or drain regions have a first height, and the third and fourth source or drain regions have a second height that is greater than the first height.

Example 5 includes the integrated circuit of any one of Examples 1-4, wherein each of the first, second, third, and fourth source or drain regions have substantially the same height.

Example 6 includes the integrated circuit of any one of Examples 1-5, further comprising a dielectric structure extending along the second direction between the first semiconductor device and the second semiconductor device.

Example 7 includes the integrated circuit of Example 6, wherein the dielectric structure electrically isolates the second source or drain region from the third source or drain region.

Example 8 includes the integrated circuit of Example 6 or 7, wherein the dielectric structure includes a high-k liner and a low-k fill material.

Example 9 includes the integrated circuit of any one of Examples 1-8, wherein the one or more first semiconductor bodies are collinear along the first direction with corresponding ones of the plurality of second semiconductor bodies.

Example 10 includes the integrated circuit of any one of Examples 1-9, wherein an uppermost surface of a topmost one of the one or more first semiconductor bodies is coplanar with an uppermost surface of a topmost one of the second semiconductor bodies.

Example 11 includes the integrated circuit of any one of Examples 1-10, wherein a bottom surface of the first gate structure beneath the one or more first semiconductor bodies is higher than a bottom surface of the second gate structure beneath the second semiconductor bodies.

Example 12 includes the integrated circuit of any one of Examples 1-11, wherein the one or more first semiconductor bodies and the plurality of second semiconductor bodies are semiconductor nanoribbons.

Example 13 includes the integrated circuit of any one of Examples 1-12, wherein the one or more first semiconductor bodies and the plurality of second semiconductor bodies are semiconductor nanosheets.

Example 14 includes the integrated circuit of any one of Examples 1-13, wherein the one or more first semiconductor bodies and the plurality of second semiconductor bodies comprise silicon, germanium, or a combination of both.

Example 15 is a printed circuit board comprising the integrated circuit of any one of Examples 1-14.

Example 16 is an electronic device that includes a chip package having one or more dies. At least one of the one or more dies includes a first semiconductor device comprising one or more first semiconductor nanoribbons extending in a first direction between a first source or drain region and a second source or drain region and a first gate structure extending in a second direction over the one or more first semiconductor nanoribbons, and a second semiconductor device comprising a plurality of second semiconductor nanoribbons extending in the first direction between a third source or drain region and a fourth source or drain region and a second gate structure extending in the second direction over the plurality of second semiconductor nanoribbons. The second direction is substantially orthogonal to the first direction. A total number of the nanoribbons of the second semiconductor device is greater than a total number of the nanoribbons of the first semiconductor device. The plurality of second semiconductor nanoribbons includes at least one nanoribbon that is coplanar with a portion of a substrate beneath the one or more first semiconductor nanoribbons.

Example 17 includes the electronic device of Example 16, wherein the plurality of second semiconductor nanoribbons includes at least one nanoribbon that is lower than any nanoribbon of the one or more first semiconductor nanoribbons along a third direction substantially orthogonal to the first and second directions.

Example 18 includes the electronic device of Example 16 or 17, wherein a bottom surface of the first source or drain region and second source or drain region is at least 10 nm higher than a bottom surface of the third source or drain region and the fourth source or drain region along a third direction substantially orthogonal to the first and second directions.

Example 19 includes the electronic device of any one of Examples 16-18, wherein the first and second source or drain regions have a first height, and the third and fourth source or drain regions have a second height that is greater than the first height.

Example 20 includes the electronic device of any one of Examples 16-19, wherein each of the first, second, third, and fourth source or drain regions have substantially the same height.

Example 21 includes the electronic device of any one of Examples 16-20, wherein the at least one of the one or more dies further comprises a dielectric structure extending along the second direction between the first semiconductor device and the second semiconductor device.

Example 22 includes the electronic device of any one of Examples 16-21, wherein the one or more first semiconductor nanoribbons are collinear along the first direction with corresponding ones of the plurality of second semiconductor nanoribbons.

Example 23 includes the electronic device of any one of Examples 16-22, wherein a bottom surface of the first gate structure beneath the one or more first semiconductor nanoribbons is higher than a bottom surface of the second gate structure beneath the second semiconductor nanoribbons.

Example 24 includes the electronic device of any one of Examples 16-23, wherein the one or more first semiconductor nanoribbons and the plurality of second semiconductor nanoribbons comprise silicon, germanium, or a combination of both.

Example 25 includes the electronic device of any one of Examples 16-24, further comprising a printed circuit board, wherein the chip package is coupled to the printed circuit board.

Example 26 is a method of forming an integrated circuit. The method includes forming a base semiconductor layer on a first region of a semiconductor substrate such that the base semiconductor layer is not present on a second region of the semiconductor substrate, forming a first number of semiconductor layers over the first region of the substrate on the base semiconductor layer and a second number of semiconductor layers over the second region of the substrate with the second number being greater than the first number, forming a first fin comprising the first number of semiconductor layers and the base semiconductor layer extending lengthwise along a first direction and a second fin comprising the second number of semiconductor layers extending lengthwise along the first direction, forming first source or drain regions at ends of the first number of semiconductor layers and second source or drain regions at ends of the second number of semiconductor layers, and forming a first gate structure extending in a second direction over the first number of semiconductor layers and a second gate structure extending in the second direction over the second number of semiconductor layers.

Example 27 includes the method of Example 26, wherein forming the first source or drain regions comprises forming the first source or drain regions at ends of the base semiconductor layer.

Example 28 includes the method of Example 26 or 27, wherein the first fin extends collinearly with the second fin along the first direction.

Example 29 includes the method of any one of Examples 26-28, further comprising forming a dielectric structure extending in the second direction between the first fin and the second fin.

Example 30 is an integrated circuit that includes a first semiconductor device comprising one or more first semiconductor nanoribbons extending in a first direction between a first source or drain region and a second source or drain region and a first gate structure extending in a second direction over the one or more first semiconductor nanoribbons, and a second semiconductor device comprising a plurality of second semiconductor nanoribbons extending in the first direction between a third source or drain region and a fourth source or drain region and a second gate structure extending in the second direction over the plurality of second semiconductor nanoribbons. The second direction is substantially orthogonal to the first direction. The plurality of second semiconductor nanoribbons includes at least one nanoribbon that is lower than any nanoribbon of the one or more first semiconductor nanoribbons along a third direction substantially orthogonal to the first and second directions.

Example 31 includes the integrated circuit of Example 30, wherein the plurality of second semiconductor nanoribbons includes at least one nanoribbon that is coplanar with a portion of a substrate beneath the first gate structure.

Example 32 includes the integrated circuit of Example 30 or 31, wherein the first and second source or drain regions have a first height, and the third and fourth source or drain regions have a second height that is greater than the first height.

Example 33 includes the integrated circuit of any one of Examples 30-32, wherein each of the first, second, third, and fourth source or drain regions have substantially the same height.

Example 34 includes the integrated circuit of any one of Examples 30-33, further comprising a dielectric structure extending along the second direction between the first semiconductor device and the second semiconductor device.

Example 35 includes the integrated circuit of any one of Examples 30-34, wherein the one or more first semiconductor nanoribbons are collinear along the first direction with corresponding ones of the plurality of second semiconductor nanoribbons.

Example 36 includes the integrated circuit of any one of Examples 30-35, wherein a bottom surface of the first gate structure beneath the one or more first semiconductor nanoribbons is higher than a bottom surface of the second gate structure beneath the second semiconductor nanoribbons.

Example 37 includes the integrated circuit of any one of Examples 30-36, wherein the one or more first semiconductor nanoribbons and the plurality of second semiconductor nanoribbons comprise silicon, germanium, or a combination of both.

Example 38 includes the integrated circuit of any one of Examples 30-37, wherein a total number of the nanoribbons of the second semiconductor device is greater than a total number of the nanoribbons of the first semiconductor device.

Example 39 is a printed circuit board comprising the integrated circuit of any one of Examples 30-38.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device comprising one or more first semiconductor bodies extending in a first direction between a first source or drain region and a second source or drain region, and a first gate structure extending in a second direction over the one or more first semiconductor bodies, the second direction substantially orthogonal to the first direction; and
a second semiconductor device comprising a plurality of second semiconductor bodies extending in the first direction between a third source or drain region and a fourth source or drain region, and a second gate structure extending in the second direction over the plurality of second semiconductor bodies;
wherein a total number of the semiconductor bodies of the second semiconductor device is greater than a total number of the semiconductor bodies of the first semiconductor device and wherein the plurality of second semiconductor bodies includes at least one body that is coplanar with a portion of a substrate beneath the one or more first semiconductor bodies.

2. The integrated circuit of claim 1, wherein the plurality of second semiconductor bodies includes at least one semiconductor body that is lower than any semiconductor body of the one or more first semiconductor bodies along a third direction substantially orthogonal to the first and second directions.

3. The integrated circuit of claim 1 or 2, wherein a bottom surface of the first source or drain region and second source or drain region is at least 10 nm higher than a bottom surface of the third source or drain region and the fourth source or drain region along a third direction substantially orthogonal to the first and second directions.

4. The integrated circuit of any one of claims 1 through 3, wherein the first and second source or drain regions have a first height, and the third and fourth source or drain regions have a second height that is greater than the first height.

5. The integrated circuit of any one of claims 1 through 3, wherein each of the first, second, third, and fourth source or drain regions have substantially the same height.

6. The integrated circuit of any one of claims 1 through 3, further comprising a dielectric structure extending along the second direction between the first semiconductor device and the second semiconductor device.

7. The integrated circuit of claim 6, wherein the dielectric structure electrically isolates the second source or drain region from the third source or drain region.

8. The integrated circuit of claim 6 or 7, wherein the dielectric structure includes a high-k liner and a low-k fill material.

9. The integrated circuit of any one of claims 1 through 8, wherein the one or more first semiconductor bodies are collinear along the first direction with corresponding ones of the plurality of second semiconductor bodies.

10. The integrated circuit of any one of claims 1 through 9, wherein an uppermost surface of a topmost one of the one or more first semiconductor bodies is coplanar with an uppermost surface of a topmost one of the second semiconductor bodies.

11. The integrated circuit of any one of claims 1 through 10, wherein a bottom surface of the first gate structure beneath the one or more first semiconductor bodies is higher than a bottom surface of the second gate structure beneath the second semiconductor bodies.

12. The integrated circuit of any one of claims 1 through 11, wherein the one or more first semiconductor bodies and the plurality of second semiconductor bodies are semiconductor nanoribbons.

13. The integrated circuit of any one of claims 1 through 12, wherein the one or more first semiconductor bodies and the plurality of second semiconductor bodies are semiconductor nanosheets.

14. The integrated circuit of any one of claims 1 through 13, wherein the one or more first semiconductor bodies and the plurality of second semiconductor bodies comprise silicon, germanium, or a combination of both.

15. A printed circuit board comprising the integrated circuit of any one of claims 1 through 14.
